# EUROPÄISCHE PATENTSCHRIFT

(11) **EP 1 102 526 B1**
(45) Veröffentlichungstag und Bekanntmachung des Hinweises auf die Patenterteilung: **30.08.2006**
(21) Anmeldenummer: 00125138.8
(22) Anmeldetag: 17.11.2000
(51) Int. Cl.: H05K 7/14, G11B 33/12, H01R 31/06

(54) **Montagesystem für die reihenweise Montage von Steckeinschüben**
System for mounting of plug-in units in rows
Système de montage en rangées de modules enfichables

(30) Priorität: 19.11.1999 DE 19955783
(43) Veröffentlichungstag der Anmeldung: 23.05.2001
(73) Patentinhaber: Fujitsu Siemens Computers GmbH, 80807 München (DE)
(72) Erfinder: Nehling, Kornelius, 33605 Bielefeld (DE)

(56) Entgegenhaltungen:
- DE-U- 29 818 775
- US-A- 4 790 760
- US-A- 5 822 184
- US-A- 6 142 796

## Beschreibung

Die vorliegende Erfindung betrifft ein Montagesystem für die reihenweise Montage von Steckeinschüben mit in Reihenrichtung unterschiedlichen, vorgegebenen Abmessungen in einem elektronischen Gerät, wobei die Steckeinschübe jeweils über einen an ihrer in Einschubrichtung voreilenden Rückseite angeordneten Stecker mit einem der an der Rückplatte (backplane) des Gerätes in Reihenrichtung hintereinander angeordneten Gegenstecker gekuppelt werden.

Es ist mehr und mehr üblich, bei elektronischen Geräten, wie etwa Computern, einzelne Gerätemodule als Steckeinschübe zu montieren, die über ihre Stecker und die Gegenstecker der Rückplatte elektrisch mit dem Gerät verbunden werden. Auf diese Weise ist es möglich, daß ein Benutzer sich seinen Computer individuell konfiguriert, wie allgemein bekannt ist und deshalb nicht näher beschrieben werden zu braucht (siehe z.B. US-A-5 822 184).

Da die Steckeinschübe unterschiedliche Abmessungen haben können, ist es im allgemeinen erforderlich, einen Steckplatz so zu bemessen, daß der größte in Frage kommende Steckeinschub Platz hat. Wenn dann ein Steckeinschub mit kleineren Abmessungen montiert wird, bleibt ein Teil des Raumes ungenutzt.

Das oben beschriebene Problem tritt überall da auf, wo Steckeinschübe einer unterschiedlichen Art oder auch Steckeinschübe der gleichen Art, jedoch mit unterschiedlichen Abmessungen eingebaut werden können.

Ein typisches Beispiel für den letzteren Fall sind Computer, in die mehrere Festplattenlaufwerke in einer Reihe übereinander eingebaut werden können. An einer solchen Konfiguration wird die vorliegende Erfindung erläutert, wobei diese jedoch nicht darauf beschränkt ist, sondern auch andere Steckeinschübe und beispielsweise auch eine Anordnung der Steckeinschübe nebeneinander sinngemäß erfaßt.

Server und angeschlossene Speichererweiterungseinheiten werden zunehmend mit im Betrieb tauschbaren Festplattenlaufwerken ausgerüstet. Dadurch kann in redundanten Konfigurationen eine ausgefallene Festplatte getauscht werden, ohne das System herunterfahren zu müssen.

Dazu werden heute in der Regel Festplattenlaufwerke mit einem sogenannten SCA-2-Steckverbinder (SCA = Single Connector Attach) eingesetzt, über den sowohl der Anschluß an den SCSI-Bus als auch die Stromversorgung und die Codierung der Festplattenlaufwerke erfolgt. Die entsprechenden Gegenstekker zu den Steckern der Festplattenlaufwerke sind auf einer Rückplatte (backplane) montiert, von der aus die Laufwerke versorgt werden. Die Laufwerke sind in Rahmen montiert, die diese mechanisch schützen und die Handhabung beim Wechseln erleichtern.

Festplattenlaufwerke sind im allgemeinen in zwei unterschiedlichen Höhenabmessungen erhältlich, nämlich mit einer Höhe von 1" bzw. einer Höhe von 1,6"; die übrigen Abmessungen, d.h. also Breite und Tiefe, sind bei beiden Laufwerksarten gleich.

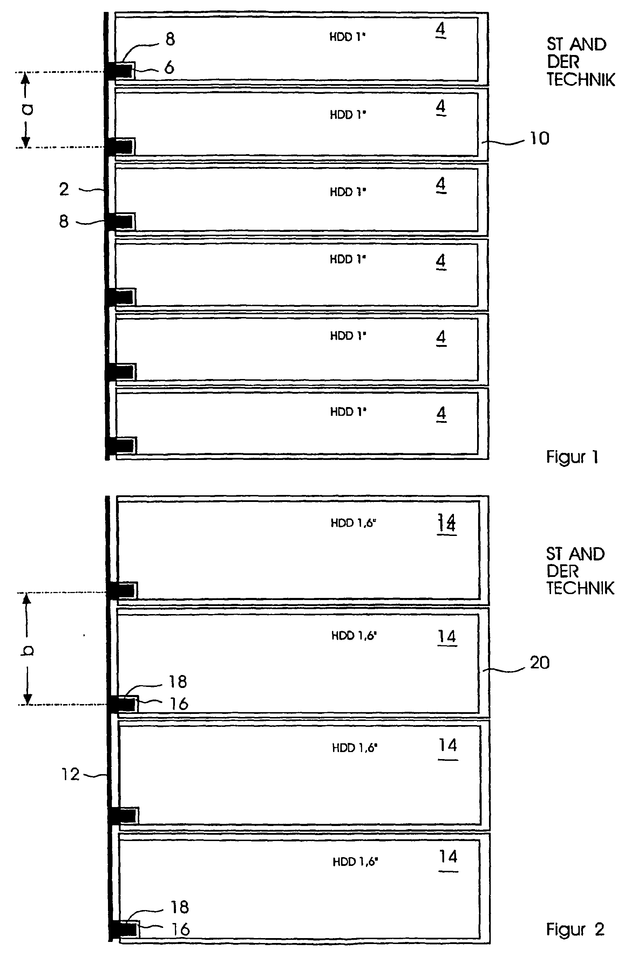

Wie eine einfache Betrachtung der Figuren 1 und 2 zum Stand der Technik zeigt, können in einem vorgegebenen Einbauraum beispielsweise sechs 1"-Laufwerke oder vier 1,6"-Laufwerke untergebracht werden. Wenn sich ein Hersteller entschließt, eine Rückplatte für sechs 1"-Laufwerke vorzusehen, dann kann er im allgemeinen ohne weitere konstruktive Veränderungen in einem für zwei 1"-Laufwerke vorgesehenen Einbauraum nur ein 1,6"-Laufwerk unterbringen und - mit Hilfe einer Steckerverlängerung - stecken. Der dabei freibleibende Raum ist verlorener Raum.

Falls sich der Hersteller entschließt, eine Rückplatte für 1,6"-Laufwerke vorzusehen, so kann er auch bei Verwendung von 1"-Laufwerken nur vier solcher Laufwerke stecken; auch in diesem Fall bleibt ein erheblicher Raum ungenutzt.

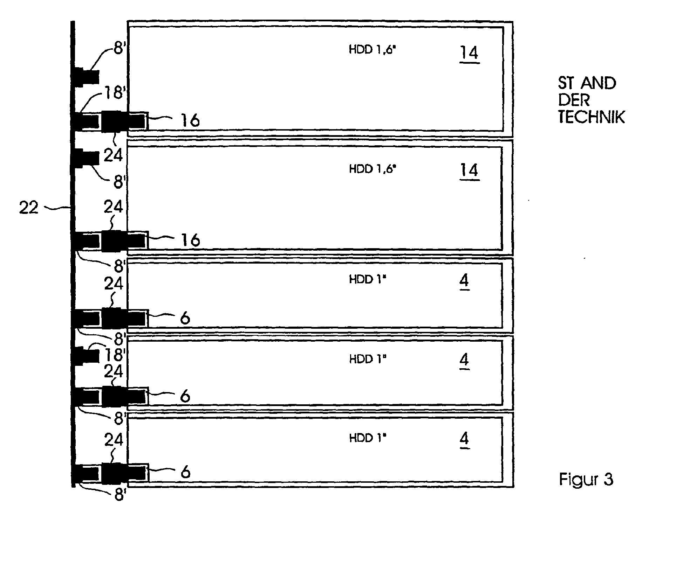

Es ist auch schon bekannt, bei einer Rückplatte für 1"-Laufwerke zusätzliche Gegenstecker anzubringen derart, daß - unter Verwendung von Steckerverlängerungen - Laufwerke unterschiedlicher Dicke mit besserer Raumausnutzung untergebracht werden können, wie die Figur 3 zum Stand der Technik zeigt. Die in Figur 3 dargestellte Anordnung der Rückplatte erlaubt es, sechs 1"-Laufwerke oder vier 1,6"-Laufwerke oder auch, wie dargestellt, beispielsweise drei 1"-Laufwerke und zwei 1,6"-Laufwerke unterzubringen.

Allerdings ist der Aufwand für die Anbringung und Verdrahtung zusätzlicher Gegenstecker verhältnismäßig groß und teuer.

Es ist deshalb die Aufgabe der vorliegenden Erfindung, ein Montagesystem der eingangs genannten Art zu schaffen, welches, unter Verwendung einer Standard-Rückplatte, die Unterbringung von Steckeinschüben unterschiedlicher Abmessungen in Reihenrichtung unter bestmöglicher Ausnutzung des vorgegebenen Einbauraumes ermöglicht, wobei der technische Aufwand und damit die Kosten möglichst gering sein sollen.

Diese Aufgabe ist erfindungsgemäß durch ein Montagesystem gemäß Anspruch 1 gelöst.

Diese Anordnung ermöglicht es, für einen solcherart mit mehreren Steckern ausgerüsteten Steckeinschub mehrere Steckpositionen zu finden, bei denen jeweils einer seiner Stecker mit einem Gegenstecker fluchtet, so daß sich für die Anordnung der Steckeinschübe eine größere Variationsbreite ergibt.

Um die durch die Erfindung gegebenen Vorteile auch bei herkömmlichen, mit nur einem Stecker ausgestatteten Steckeinschüben zu haben, ist in weiterer Ausgestaltung der Erfindung vorgesehen, die parallel geschalteten Stecker durch einen Adapter zu bilden, welcher einen mit diesem einzigen Stecker kuppelbaren Eingangs-Stecker und mehrere AusgangsStecker hat, von denen dann einer mit einem Gegenstecker der Rückplatte gekuppelt wird derart, daß der Steckeinschub jeweils mit bester Raumausnutzung montiert ist.

Auch diese Anordnung erlaubt es, die Steckeinschübe mit einer größeren Anordnungsvariationsbreite zu montieren und für den Fall, daß der Stecker eines Steckeinschubes nicht einem Gegenstecker der Rückplatte gegenüberliegt, den Abstand vom Stecker zu einem freien Gegenstecker mittels des Adapters zu überbrücken.

Es läßt sich etwa am Beispiel der 1"-Laufwerke und 1,6"-Laufwerke zeigen, daß mit einem einzigen Adaptertyp und ohne das Anbringen zusätzlicher Gegenstecker auf der Rückplatte beispielsweise eine Anordnung möglich wird, wie sie die Figur 3 gemäß dem Stand der Technik zeigt.

In einer weiteren Ausgestaltung der vorliegenden Erfindung ist vorgesehen, daß die Adapter jeweils eine zur Steckrichtung quer stehende Leiterplatte umfassen, auf deren einschubseitiger Fläche der Eingangsstecker und auf deren rückplattenseitiger Fläche ein oder mehrere in Reihenrichtung hintereinander angeordnete Ausgangsstecker vorgesehen sind, deren Achsen in einer gemeinsamen Ebene liegen. Die Leiterplatte enthält die Verbindungsleitungen zwischen dem Eingangstecker und den Ausgangssteckern. Leiterplatten sind in einfacher Weise preiswert herstellbar, so daß auf diese Weise hergestellte Adapter preisgünstig sein können.

Der Adapter hat stets einen Eingangsstecker und mehrere Ausgangsstecker; dabei kann die Achse des Eingangssteckers gemäß einer Ausgestaltung zwischen den Achsen zweier Ausgangsstecker verlaufen, wie anhand eines Ausführungsbeispiels dargelegt ist, oder die Achsen der Ausgangsstecker können gegenüber der Achse des Eingangssteckers zu einer Seite hin versetzt sein, wie nicht näher dargestellt ist.

Für die Übereinander-Montage von Steckeinschüben mit einer ersten vorgegebenen Höhenabmessung und Steckeinschüben mit einer zweiten, größeren vorgegebenen Höhenabmessung, also beispielsweise von 1"-Laufwerken und 1,6"-Laufwerken, haben gemäß einer bevorzugten Ausgestaltung der Erfindung die Gegenstecker der Rückplatte einen Teilungsabstand entsprechend der ersten vorgegebenen Höhenabmessung, und die Stekker bzw. Ausgangsstecker haben einen Abstand voneinander, welcher der Hälfte des Teilungsabstandes der Gegenstecker entspricht. Die Steckeinschübe können dann jeweils so angeordnet werden, daß einer der beiden Stecker des Steckeinschubes bzw. Ausgangsstecker des Adaptes zu einem Gegenstecker der Rückplatte fluchtet, womit eine raumsparende Anordnung der Festplattenlaufwerke unterschiedlicher Dicke möglich ist.

In weiterer Ausgestaltung der Erfindung ist vorgesehen, daß jedem Gegenstecker der Rückplatte wenigstens eine Zustands-Signallampe zugeordnet ist, und daß jedem Steckeinschub ein von der Vorderseite desselben zur Rückseite verlaufender Lichtleiter zugeordnet ist, dessen rückplattenseitiges Ende sich entsprechend der Anzahl der Stecker bzw. Ausgangsstekker des dem Steckereinschub zugeordneten Adapters verzweigt. Wenn demnach ein Adapter mit zwei Ausgangssteckern vorgesehen ist, dann ist auch der Lichtleiter an seinem rückplattenseitigen Ende in zwei Äste verzweigt, so daß jeder Zustandssignallampe ein Lichtleiterende zugeordnet ist.

In der Zeichnung sind mehrere Ausführungsbeispiele der Erfindung dargestellt, die im folgenden näher beschrieben werden.

### Kurze Beschreibung der Zeichnungen

- Fig. 1: zeigt schematisch eine Anordnung von mehreren 1"-Laufwerken an einer Rückplatte gemäß dem Stand der Technik;
- Fig. 2: zeigt schematisch die Anordnung von mehreren 1,6-"Laufwerken an einer Rückplatte gemäß dem Stand der Technik;
- Fig. 3: zeigt schematisch die Anordnung von mehreren 1"-Laufwerken und mehreren 1,6-"-Laufwerken an einer Rückwand gemäß dem Stand der Technik;
- Fig. 4: zeigt schematisch die Anordnung von mehreren 1"-Laufwerken und mehreren 1,6"-Laufwerken an einer Rückplatte gemäß der Erfindung.

Fig. 1 zeigt in einer schematischen Seitenansicht eine Rückplatte (backplane) 2 eines nicht dargestellten Computers, an der sechs 1"-Laufwerke 4 (HDD 1" = hard disk drive 1") montiert sind. Die Laufwerke 4 sind jeweils mit einem versenkten Stecker 6 ausgestattet, in den jeweils ein an der Rückplatte 2 angeordneter Gegenstecker 8 eingreift.

Die Laufwerke 4 sind jeweils in einem Rahmen 10 angeordnet, welcher in an sich bekannter Weise in das nicht dargestellte Gehäuse des Computers so eingesetzt werden kann, daß das Laufwerk richtig plaziert und fest gehalten wird.

Wie die Fig. 1 erkennen läßt, haben die Gegenstecker 8 einen Teilungsabstand a, welcher auf die Dickenabmessung der Laufwerke abgestimmt ist.

Fig. 2 zeigt in einer Ansicht ähnlich der Fig. 1 eine Rückplatte 12, an der vier 1,6"-Laufwerke 14 montiert sind. Die Laufwerke 14 sind über ihre Stecker 16 mit an der Rückplatte 12 angeordneten Gegensteckern 18 elektrisch verbunden. Auch die Laufwerke 14 sind in an deren Größenabmessung angepaßten Rahmen 20 aufgenommen, die ihrerseits in das Gehäuse des Computers eingesetzt werden. Die Gegenstecker 18 haben im Fall der Fig. 2 einen Teilungsabstand b, welcher an die Dickenabmessung der 1,6"-Laufwerke angepaßt ist, d.h., b ist größer als a.

Wie ein Vergleich der Fig. 1 und 2 erkennen läßt, können in etwa den gleichen Einbauraum entweder sechs 1"-Laufwerke oder vier 1,6"-Laufwerke eingebaut werden, d.h., jeweils drei 1"-Laufwerke nehmen den gleichen Einbauraum ein wie zwei 1,6"-Laufwerke.

Wenn beispielsweise eine Anordnung verwirklicht werden soll, die der Anordnung der Fig. 3 entspricht, dann ermöglicht weder die Rückplatte 2 der Fig. 1 noch die Rückplatte 12 der Fig. 2 ein direktes Stecken aller Laufwerke, da nicht jedem Stecker eines Laufwerkes jeweils ein Gegenstekker der Rückplatte gegenüberliegt. Fig. 3 zeigt eine Rückplatte 22, bei der sowohl den Gegensteckern 8 gemäß der Fig. 1 entsprechende Gegenstecker 8' als auch den Gegensteckern 18 der Fig. 2 entsprechende Gegenstecker 18' vorgesehen sind, um beispielsweise die in Fig. 3 dargestellte Anordnung zu ermöglichen. Wie die Fig. 3 erkennen läßt, wäre auch eine Anordnung möglich, bei der drei 1"-Laufwerke über zwei 1,6"-Laufwerken angeordnet sind.

Da bei der Anordnung gemäß der Fig. 3 die nicht belegten Gegenstecker nicht von Steckern der Laufwerke aufgenommen werden, stellen diese ein Hindernis für das vollständige Einschieben der Laufwerke in die Steckplätze dar. Es müssen deshalb zwischen den Steckern 6 bzw. 16 der Laufwerke 4 bzw. 14 und den zugeordneten Gegensteckern 8' bzw. 18' jeweils Verlängerungen 24 vorgesehen werden, welche den erforderlichen Abstand der Rückwände der Laufwerke von den nicht belegten Gegensteckern ermöglichen.

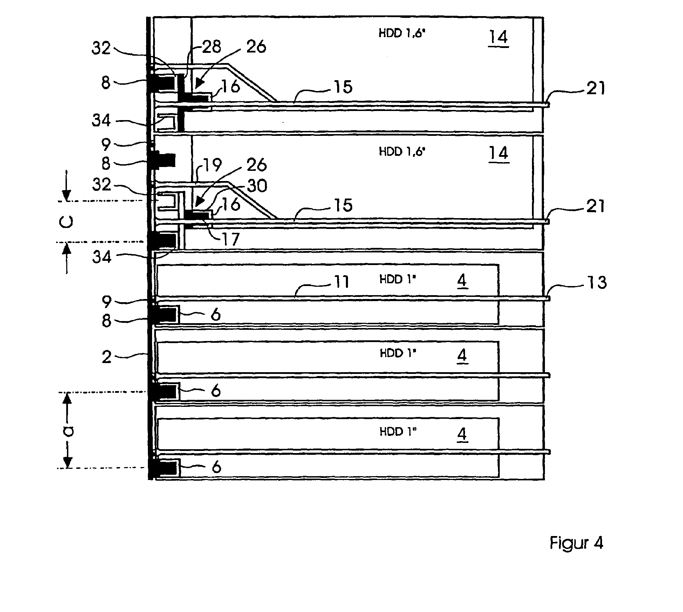

Fig. 4 zeigt eine erfindungsgemäße Laufwerksanordnung entsprechend der Fig. 3. Dabei sind in der unteren Hälfte des Einbauraumes drei 1"-Laufwerke und in der oberen Hälfte des Einbaurames zwei 1,6"-Laufwerke angeordnet. Die Rückplatte 2 mit den Gegensteckern 8 entspricht exakt der Gegenplatte 2 der Fig. 1.

Die unteren Laufwerke 4 können wie im Falle der Fig. 1 direkt gesteckt werden, d.h. die Stecker 6 nehmen die Gegenstecker 8 auf, so daß Verlängerungen wie im Fall der Fig. 3 nicht erforderlich sind.

In die Stecker 16 der oberen Laufwerke 14 ist jeweils ein Adapter 26 gesteckt, welcher die Verbindung zu einem der Gegenstecker 8 herstellt. Die beiden Adapter 26 sind einander gleich. Sie weisen jeweils eine zu der Rückplatte 8 parallele Leiterplatte 28 auf, an deren laufwerksseitiger Fläche ein Eingangsstecker 30 angeordnet ist, und an deren rückplattenseitiger Fläche zwei Ausgangsstecker 32, 34 angeordnet sind.

Der Abstand c der beiden Ausgangsstecker 32, 34 voneinander ist die Hälfte des Teilungsabstandes a der Gegenstecker 8, d.h. c = 1/2 a. Wie die Fig. 4 erkennen läßt, besteht damit die Möglichkeit, die Laufwerke 14 mit einem Versatz ihrer Stecker 16 gegenüber den Gegensteckern 8 anzuordnen. Mit der Ausgestaltung des Adapters 26 gemäß der Fig. 4 ist demnach die Möglichkeit gegeben, das Laufwerk 14 so anzuordnen, daß sein Stecker entweder mit einem Abstand 1/4 a unterhalb des nächst höheren Gegensteckers oder mit einem Abstand 1/4 a oberhalb des nächst tieferen Gegensteckers angeordnet wird, so daß gegenüber der grundsätzlich auch bestehenden Möglichkeit, den Stecker 16 fluchtend zu einem Gegenstecker auszurichten, zwei weitere Anordnungen verwirklicht werden können.

Wie die Fig. 4 erkennen läßt, ist jedem Gegenstecker 8 der Rückplatte 2 jeweils eine Zustands-Signallampe 9 zugeordnet, welche einen bestimmten Betriebszustand des Gegensteckers anzeigt. Es ist ganz allgemein bekannt, das Licht dieser Zustands-Signallampen über einen am Rahmen oder am Laufwerk befestigten Lichtleiter von der Rückplatte zur Vorderfront der Laufwerke zu leiten, wie beispielsweise bei den Laufwerken 4 in Fig. 4 zu erkennen ist. Der Lichtleiter 11 nimmt das von der Zustands-Signallampe 9 ausgehende Licht auf und leitet es an das frontseitige Ende 13 des Lichtleiters 11.

Wie weiter in Fig. 4 zu erkennen ist, sind die den Laufwerken 14 zugeordneten Lichtleiter 15 an ihrem rückplattenseitigen Ende in zwei Arme 17, 19 verzweigt, deren jeder einem der beiden Ausgangsstecker 32 bzw. 34 zugeordnet ist, so daß unabhängig davon, ob der Ausgangsstecker 32 oder der Ausgangsstecker 34 mit einem Gegenstecker 8 gekuppelt wird, das Licht einer zugeordneten Zustands-Signallampe an das frontseitige Ende 21 des Lichtleiters 15 geleitet wird.

Falls ein Adapter mit mehr als zwei Steckerausgängen verwendet wird, wird auch der zugeordnete Lichtleiter in eine entsprechende Anzahl von Armen verzweigt.

## Patentansprüche

1. Montagesystem für die reihenweise Montage von Steckeinschüben mit in Reihenrichtung unterschiedlichen, vorgegebenen Abmessungen in einem elektronischen Gerät, wobei Steckeinschübe (4, 14) vorgesehen sind, die jeweils einen an ihrer in Einschubrichtung voreilenden Rückseite angeordneten Stecker aufweisen, zum Kuppeln mit einem der an der Rückplatte (2) des Gerätes in Reihenrichtung hintereinander angeordneten Gegenstecker (8), die an der Rückplatte (2) mit einem der kleinsten vorgegebenen Abmessung der Steckeinschübe (4) entsprechenden Teilungsabstand (a) angeordnet sind, **dadurch gekennzeichnet, daß** Steckeinschübe (4, 14) mit in Reihenrichtung unterschiedlicher Abmessungen vorgesehen sind und daß zumindest die Steckeinschübe (14) mit größerer Abmessung jeweils wenigstens zwei in Reihenrichtung hintereinander angeordnete, zueinander parallel geschaltete Stecker (32, 34) aufweisen, deren Abstand (c) voneinander kleiner als der Teilungsabstand (a) der Gegenstecker (8) ist.

2. Montagesystem nach Anspruch 1, **dadurch gekennzeichnet, daß** die parallel geschalteten Stecker (32, 34) der Stekkeinschübe (14) jeweils durch einen Adapter (26) gebildet sind, welcher einen mit einem einzigen vorgesehenen Stecker (16) des Steckeinschubes (14) kuppelbaren Eingangsstecker (30) und wenigstens zwei Ausgangsstecker (32, 34) hat, die mit dem Eingangsstecker (16) verbunden und zueinander parallel geschaltet sind, und die mit jeweils einem Gegenstecker (8) der Rückplatte (2) kuppelbar sind.

3. Montagesystem nach Anspruch 2, **dadurch gekennzeichnet, daß** die Adapter (26) jeweils eine zur Steckrichtung quer stehende Leiterplatte (28) umfassen, auf deren einschubseitiger Fläche der Eingangsstecker (16) und auf deren rückplattenseitiger Fläche die Ausgangsstecker (32, 34) angeordnet sind.

4. Montagesystem nach den Ansprüchen 2 oder 3, **dadurch gekennzeichnet, daß** die Achsen der Ausgangsstecker zu einer Seite der Achse des Eingangssteckers hin versetzt angeordnet sind.

5. Montagesystem nach den Ansprüchen 2 oder 3, **dadurch gekennzeichnet, daß** die Achse des Eingangssteckers (16) zwischen den Achsen zweier in Reihenrichtung davor bzw. dahinter angeordneten Ausgangssteckern (32, 34) angeordnet ist.

6. Montagesystem nach einem der Ansprüche 1 bis 5, **dadurch gekennzeichnet, daß** für die Übereinander-Montage von ersten Steckeinschüben (4) mit einer kleineren Höhe (1") und von zweiten Steckeinschüben (14) mit einer größeren Höhe (1,6") die Gegenstecker (8) der Rückplatte (2) einen Teilungsabstand (a) haben, welcher an die kleinere Höhe (1") angepaßt ist, und daß die Steckeinschübe (14) mit der größeren Höhe (1,6") jeweils zwei übereinander angeordnete Stecker (32, 34) haben, deren Abstand (c) der Hälfte des Teilungsabstandes (a) der Gegenstecker (8) entspricht.

7. Montagesystem nach einem der Ansprüche 1 bis 6, **dadurch gekennzeichnet, daß** jedem Gegenstecker (8) der Rückplatte wenigstens eine Zustands-Signallampe (9) zugeordnet ist, und daß jedem Steckeinschub (14) ein von der Vorderseite desselben zur Rückseite verlaufender Lichtleiter (15) zugeordnet ist, welcher sich entsprechend der Anzahl der an den Steckeinschüben größeren Abmessung vorgesehenen Stecker bzw. der Ausgangsstecker (32, 34) des dem Steckeinschub (14) zugeordneten Adapters (26) verzweigt.

## Claims

1. Modular enclosure system for installing plug-in units in rows in an item of electronic equipment, said plug-in units having different specified dimensions in the row direction, where plug-in units (4, 14) are provided, which each have a connector arranged on their rear face (the leading face in the insertion direction) for connecting to a mating connector (8) arranged in succession in the row direction on the backplane (2) of the equipment with a pitch spacing (a) on the backplane (2) equal to the smallest specified height dimension of the plug-in units (4), **characterized in that** plug-in units (4, 14) are provided with different dimensions in the row direction and that at least the plug-in units (14) having the larger dimension each have at least two connectors (32, 34) arranged in succession in the row direction and connected in parallel with each other, the separation (c) between these connectors being less than the pitch spacing (a) of the mating connectors (8).

2. Modular enclosure system according to Claim 1, **characterized in that** the parallel-connected connectors (32, 34) of the plug-in units (14) are each formed by an adapter (26) that has one input connector (30) that can be connected to a single provided connector (16) of the plug-in unit (14) and at least two output connectors (32, 34), which are connected to the input connector (16) and in parallel with each other, and which can be connected to one mating connector (8) of the backplane (2) in each case.

3. Modular enclosure system according to Claim 2, **characterized in that** the adapters (26) each comprise a printed circuit board (28) lying at right angles to the insertion direction, on whose side facing the plug-in is arranged the input connector (16), and on whose side facing the backplane are arranged the output connectors (32, 34).

4. Modular enclosure system according to Claims 2 or 3, **characterized in that** the axes of the output connectors are offset to one side of the axis of the input connector.

5. Modular enclosure system according to Claims 2 or 3, **characterized in that** the axis of the input connector (16) is arranged between the axes of two output connectors (32, 34) arranged before and after it in the row direction.

6. Modular enclosure system according to one of the Claims 1 to 5, **characterized in that** for installing one above the other first plug-in units (4) having a smaller height (1") and second plug-in units (14) having a larger height (1.6"), which is designed to equal the smaller height (1"), and that the plug-in units (14) having the larger height (1.6") each have two connectors (32, 34) arranged one above the other, whose separation (c) equals half the pitch spacing (a) of the mating connectors (8).

7. Modular enclosure system according to one of the Claims 1 to 6, **characterized in that** at least one status signal lamp (9) is assigned to each mating connector (8) of the backplane, and that each plug-in unit (14) is assigned an optical fibre (15) running from the front face of said unit to the rear face, which is branched according to the number of connectors provided on the plug-in units having the larger dimension, or the output connectors (32, 34) of the adapter (26) assigned to the plug-in unit (14).

## Revendications

1. Système de montage pour monter en rangées dans un appareil électronique des modules enfichables ayant des dimensions prédéfinies différentes dans le sens de la rangée, des modules enfichables (4, 14) étant prévus qui présentent à chaque fois une fiche disposée sur leur côté arrière en ayant dans le sens de l'enfichage pour l'accouplement avec l'une des prises homologues (8) disposées les unes derrière les autres dans le sens de la rangée sur le panneau arrière (2) de l'appareil, lesquelles sont disposées sur le panneau arrière (2) avec un pas d'espacement (a) qui correspond à la dimension prédéfinie la plus petite des modules enfichables (4), **caractérisé en ce que** les modules enfichables (4, 14) sont prévus avec des dimensions différentes dans le sens de la rangée et qu'au moins les modules enfichables (14) ayant la plus grande taille présentent à chaque fois au moins deux fiches (32, 34) branchées en parallèle l'une avec l'autre et disposées l'une derrière l'autre dans le sens de la rangée, dont l'espacement (c) l'une par rapport à l'autre est inférieur au pas d'espacement (a) des fiches homologues (8).

2. Système de montage selon la revendication 1, **caractérisé en ce que** les fiches (32, 34) branchées en parallèle des modules enfichables (14) sont à chaque fois formées par un adaptateur (26) qui possède une prise d'entrée (30) pouvant être accouplée avec une unique fiche (16) prévue du module enfichable (14) et au moins deux fiches de sortie (32, 34) qui sont reliées avec la prise d'entrée (16) et branchées en parallèle et qui peuvent à chaque fois être accouplées avec une prise homologue (8) du panneau arrière (2).

3. Système de montage selon la revendication 2, **caractérisé en ce que** les adaptateurs (26) comprennent à chaque fois un circuit imprimé (28) disposé transversalement par rapport au sens de l'enfichage sur la surface côté module duquel est prévue la prise d'entrée (16) et sur la surface côté panneau arrière duquel sont disposées les fiches de sortie (32, 34).

4. Système de montage selon l'une des revendications 2 ou 3, **caractérisé en ce que** les axes des fiches de sortie sont disposés décalés vers un côté de l'axe de la prise d'entrée.

5. Système de montage selon l'une des revendications 2 ou 3, **caractérisé en ce que** l'axe de la prise d'entrée (16) est disposé entre les axes de deux fiches de sortie (32, 34) disposées devant ou derrière celle-ci.

6. Système de montage selon l'une des revendications 1 à 5, **caractérisé en ce que** pour permettre le montage superposé de premiers modules enfichables (4) ayant une hauteur plus faible (1") et de deuxièmes modules enfichables (14) ayant une hauteur plus élevée (1,6"), les prises homologues (8) du panneau arrière (2) présentent un pas d'espacement (a) qui est adapté à la plus petite hauteur (1") et que les modules enfichables (14) ayant la hauteur plus élevée (1,6") possèdent à chaque fois deux fiches (32, 34) disposées l'une au-dessus de l'autre dont l'espacement (c) correspond à la moitié du pas d'espacement (a) des prises homologues (8).

7. Système de montage selon l'une des revendications 1 à 6, **caractérisé en ce qu'**à chaque prise homologue (8) du panneau arrière est associé au moins un voyant de signalisation d'état (9) et qu'à chaque module enfichable (14) est associée une fibre optique (15) qui s'étend de la face avant de celui-ci à la face arrière, laquelle se ramifie en fonction du nombre de fiches prévues sur les modules enfichable de la plus grande taille ou de fiches de sortie (32, 34) de l'adaptateur (26) associé au module enfichable (14).
